# EUROPEAN PATENT APPLICATION

(11) **EP 1 767 607 A1**
(43) Date of publication of application: **28.03.2007**
(21) Application number: 06019670.6
(22) Date of filing: 20.09.2006
(51) Int. Cl.: C09J 7/02, B32B 27/08, B32B 27/40

(54) **Pressure-sensitive adhesive sheet, production method thereof and method of processing articles**

(30) Priority: 22.09.2005 JP 2005276369
(71) Applicant: NITTO DENKO CORPORATION, Ibaraki Osaka, 567-8680 (JP)
(72) Inventor: Kontani, Tomohiro Nitto Denko Corporation, Osaka 567-8680 (JP); Akazawa, Kouji Nitto Denko Corporation, Osaka 567-8680 (JP); Yano, Kohei Nitto Denko Corporation, Osaka 567-8680 (JP); Yoshida, Yoshinori Nitto Denko Corporation, Osaka 567-8680 (JP)
(74) Representative: Albrecht, Thomas

(57) **Abstract**

To provide a pressure-sensitive adhesive that is used in processing an article such as a semiconductor wafer that causes neither contamination nor breakage of the semiconductor wafer during the processing, the pressure-sensitive adhesive sheet has a base, an intermediate layer, and a pressure-sensitive adhesive layer in order. The intermediate layer includes a composite film that contains urethane-based polymer and a vinyl-based polymer as active ingredients. The urethane polymer contains a component having a weight-average molecular weight of 10,000 or less in a differential molecular weight curve in a content of less than 10%.

## Description

### BACKGROUND OF THE INVENTION

### Field of the Invention

The present invention relates to a pressure-sensitive adhesive sheet, a production method thereof, and a method of processing an article using the same. In particular, it relates to a pressure-sensitive adhesive sheet and a production method thereof used in a process of hlgh-precision processing of semiconductor products such as semiconductor wafers and optical products in order to hold or protect such products. Also, it relates to a method of processing an article using such a pressure-sensitive adhesive sheet.

### Description of a Related Art

In some industrial fields such as optical industries and semiconductor industries, pressure-sensitive adhesive sheets are used in high-precision processing optical parts such as lenses or semiconductor articles such as semiconductor wafers in order to protect the surface of wafers and the like or prevent breakage thereof.

For example, in the process of producing semiconductor chips, the semiconductor chips are produced as follows. First a high-purity silicon single crystal or the like is sliced to form wafers. A predetermined circuit pattern such as IC is formed on the wafer by etching to incorporate an integrated circuit. Then, the back side of the wafer is ground by a grinder to a thickness as thin as about 100 to about 600 µm. Finally, the wafer is diced into chips. Since the semiconductor wafer in itself is thin and brittle and the circuit pattern is uneven, the wafer tends to be broken if external force is applied to the wafer when it is transported to the steps of grinding and dicing. In addition, in the step of grinding processing, grinding is performed while washing the backside of the wafer with purified water in order to remove the resultant grinding sludge or remove heat generated during the grinding. The grinding sludge and grinding water and the like could cause environmental pollution and it is necessary to prevent such pollution. Consequently, to protect, for example, the circuit pattern surface and prevent breakage of the semiconductor wafer, it has been widely practiced to apply a pressure-sensitive adhesive sheet on the circuit pattern surface of the semiconductor wafer before the operation is performed. Further, when dicing, for example, a pressure-sensitive adhesive sheet is applied to the back side of the wafer, and the wafer is diced in a glued and fixed state to form a chip. Then, the chip with the base material side down is then raised by picking the base material side with a needle and the raised chip is transferred and fixed onto a die pad.

Examples of known pressure-sensitive adhesive sheet used here include pressure-sensitive sheets, for example, those including base material sheets made of, for example, polyethylene terephthalate (PET), polyethylene (PE), polypropylene (PP), ethylene-vinyl acetate copolymers (EVA), having respective pressure-sensitive adhesive layers thereon. Japanese Patent Application Laid-open No. 61-10242 discloses a film for use in processing silicon wafers including a base material sheet with a Shore Hardness D of 40 or less having provided on a surface thereof a pressure-sensitive adhesive layer. Further, Japanese Patent Application Laid-open No. 9-253964 discloses a pressure-sensitive adhesive tape that includes a base material made of a radiation-cured composition containing a urethane acrylate-based oligomer and a reactive dilution monomer having provided thereon a pressure-sensitive adhesive layer. Japanese Patent Application Laid-open No. 61-260629 discloses a film for use in processing silicon wafers that includes a base material film with a Shore Hardness D of 40 or less having laminated an auxiliary film with a Shore Hardness D of more than 40 on one surface thereof and a pressure-sensitive adhesive layer on another surface thereof. Japanese Patent Application Laid-open No. 2000-150432 discloses a pressure-sensitive adhesive sheet having a stress relaxation rate of 40%/mtnute or more at 10% elongation in a tensile test.

However, in recent years, differences in height of unevenness of the surface of a circuit pattern on the wafer is increasing. On the other hand, thinner semiconductor wafers having thicknesses as thin as below 100 µm are being required for ultra-thin chips. For example, a pressure-sensitive adhesive sheet using a rigid base material such as one made of PET prevents wafers from curling after wafers are made thin and polished. However the pressure-sensitive adhesive sheet can not follow the unevenness on the circuit pattern on the surface of the wafer. So that the adhesion between the pressure-sensitive adhesive layer and the pattern surface becomes insufficient. This results in peeling of the sheet or penetration of polishing water or foreign matter into the pattern surface. In the case of a conventional pressure-sensitive adhesive sheet having a flexible base material such as one made of EVA, thepressure-sensitive adhesive sheet can follow up such unevenness. However, such a pressure-sensitive adhesive sheet has insufficient rigidity. So that wafers will be curled after their grinding or they will be bent due to their weight. Accordingly, a base may be considered to be made in which a rigid PET-based base material and a flexible EVA-based material are bonded together. However, if these base materials are mechanically bonded together through an adhesive, the stress given upon the lamination remains in the resultant film so that the base materials will be curled. Further, when a laminate is formed by a T-die method or a calendering method, residual stress tends to occur in the film due to heat-shrinking upon the film formation. Using a pressure-sensitive adhesive sheet with such a base in which residual stress has occurred in the production of wafers tends to cause wafers to be broken when the wafers are ground or tends to cause unnegligible curls of wafers after the grinding due to the strain in the pressure-sensitive adhesive sheet as a result of tensile stress, pressure and the like when the films are bonded together.

Japanese Patent Applications Laid-open No. 2004-122758 discloses a pressure-sensitive adhesive sheet that includes a composite layer containing a urethane polymer and a vinyl-based polymer as active ingredients as an intermediate layer, which teaches that such a pressure-sensitive adhesive sheet is effective in coping with the above-mentioned problems.

A wafer is passed through a dicing step where the wafer is cut into individual chips, and the chips are subjected to wire bonding, sealing with a resin and so on. A pressure-sensitive adhesive sheet used in these steps must not contaminate an adherend such as a wafer. Contamination on the surface of a wafer when a pressure-sensitive adhesive sheet is used in processing wafers is known to be ascribable to a low molecular weight component contained in the pressure-sensitive adhesive layer. In the case of a pressure-sensitive adhesive sheet having a composite film that contains a urethane polymer as an intermediate layer, it has also proved that the urethane polymer contained in the composite film also constitutes the source of contamination. That is, the above-mentioned pressure-sensitive adhesive sheet entails a problem due to contaminants, and the urethane prepolymer contained in the composite film is considered to migrate onto the surface of the wafer through the pressure-sensitive adhesive layer, thus increasing the amount of contamination.

The contaminants on the surface of wafers are known to give adverse influences to the shear strength of the wire-bonding. That is, in the wire-bonding performed when a semiconductor chip is produced, the bonding strength between a ball and a pad is required to be high. Organic substances or particles attached to the surface of aluminum surface on the wafer are a factor that prevents bonding of gold wire onto the surface of aluminum. Further, when a large amount of contaminant is present on the surface of aluminum, the contaminant serves as a starting point from which voids grow to cause peeling-off of the sealant resin or cracks in the sealant resin, decreasing the shear strength of the wire-bonding.

Control of contamination on the circuit surface of semiconductor wafers and semiconductor chips obtained therefrom is becoming severer particularly with increasing requirements for higher density and higher performance of integrated semiconductor circuits in recent years. Accordingly, a further improvement in low contamination property is demanded.

The present invention has been made to solve the above-mentioned problems. Accordingly, it is an object of the present invention to provide a pressure-sensitive adhesive sheet that can be used in the step of processing an article such as a semiconductor wafer, which does not cause breakage of a semiconductor wafer during grinding of the wafer even when the wafer is thin, which can follow up unevenness on the surface of a wafer or the like, and which can achieve low contamination, and a method of producing such a pressure-sensitive adhesive sheet. It is another object of the present invention to provide a method of processing an article by using such a pressure-sensitive adhesive sheet.

### SUMMARY OF THE INVENTION

The present invention provides a pressure-sensitive adhesive sheet that has a base, an intermediate layer, and a pressure-sensitive adhesive layer in order, wherein the intermediate layer includes a composite film containing a urethane polymer and a vinyl-based polymer as active ingredients and the urethane polymer contains a component having a molecular weight of 10,000 or less in a differential molecular weight curve in a content of less than 10%.

Here, the vinyl polymer may be an acrylic polymer.

Further, the composite film may be formed by reacting a polyol with a polyisocyanate in a radical-polymerizable monomer to form a urethane polymer, then coating a mixture containing the urethane polymer and the radical-polymerizable monomer on a base, and irradiating radiation to the coating to cure it.

In the present invention, the radical-polymerizable monomer may be an acrylic monomer.

The present invention provides a method of producing a pressure-sensitive adhesive sheet, which comprises coating a mixture containing a urethane polymer and a radical-polymerizable monomer on a base, irradiating radiation onto the coating to cure it to form a composite film, and providing a pressure-sensitive adhesive layer on the composite film.

Here, the mixture may be produced by reacting a polyol and a polyisocyanate in a radical-polymerizable monomer to form a urethane polymer.

The radical-polymerizable monomer may be an acrylic-based monomer.

The present invention also provides a method of processing an article, which comprises affixing any one of the pressure-sensitive adhesive sheets to the article to be hlgh-prectston-processed, and performing high-precision processing of the article in a held and/or protected state.

### BRIEF DESCRIPTION OF THE DRAWINGS

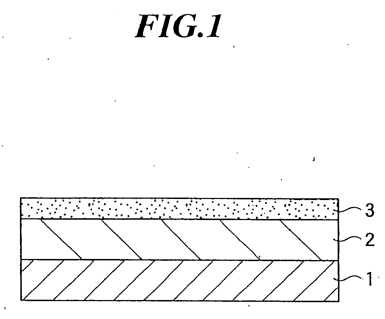

Fig. 1 is a cross-sectional view showing a layer construction of a pressure-sensitive adhesive sheet according to a first embodiment of the present invention.

### DETAILED DESCRIPTION

Hereinafter, the present invention will be described in detail.

The pressure-sensitive adhesive sheet of the present invention is a pressure-sensitive adhesive sheet that includes abasematerial, anintermediatelayer, andapressure-sensitive adhesive layer in this order. The intermediate layer includes a composite film containing a urethane polymer and a vinyl-based polymer as active ingredients. Note, however, that the urethane polymer contains a component having a molecular weight of 10,000 or less in a differential molecular weight curve in a content of less than 10%.

Note that the term "film" as used herein refers also to sheet and the term "sheet" also refers to film.

The materials constituting the base that constitutes the pressure-sensitive adhesive sheet of the present invention include polyester-based resins such as polyethylene terephthalate (PET) and polybutylene terephthalate (PBT); polyolefin-based resins such as polyethylene (PE), polypropylene (PP), high density polyethylene, and biaxially stretched polypropylene; thermoplastic resins such as polyimides (PI), polyether ether ketone (PEEK), polyvinyl chloride (PVC), polyvinylidene chloride-based resins, polyamide-based resins, polyurethane-based resins, polystyrene-based resins, acrylic-based resins, fluorine-contained based resins, cellulose-based resins, and polycarbonate-based resins; and in addition thermosetting resins. Among others, PET is preferably used since it has suitable hardness when used in processing high precision parts and further it is advantageous from the viewpoints of a variety of kinds and low price. It is preferable that the material of the film be determined appropriately depending on the kind of the pressure-sensitive adhesive layer to be provided according to the purpose and necessity. For example, when an ultraviolet ray-curing type pressure-sensitive adhesive is provided, a base having high ultraviolet transmission is preferable.

In the base, generally used additives may be used as necessary as far as the effects of the present invention are not deteriorated. Examples of such additives include antioxidants, fillers, pigments, colorants, flame retardants, antistatic agents, and ultraviolet absorbents.

In the present invention, conventional physical treatment or chemical treatments such as matting treatment, corona discharge treatment, primer treatment, crosslinking treatment (chemical crosslinking treatment with, for example, silane) may be applied to the surface of the base as necessary.

In the present invention, the base may be either of a single layer construction or of a multi-layer construction. When the base material is of a multi-layer construction, the resins that constitutes the respective layers may be the same or different.

The thickness of the base material is usually about 10 µm to about 300 µm, preferably about 30 µm to about 200 µm.

In the present invention, the composite film that constitutes an intermediate layer of the pressure-sensitive adhesive sheet contains a urethane polymer and a vinyl polymer as mentioned above.

The urethane polymer that constitutes the composite film can be obtained by reacting a polyol and a polyisocyanate. In the reaction between hydroxyl groups of the polyol and isocyanates, a catalyst may be used. For example, those catalysts that are generally used in urethane reactions, such as dibutyl tin dilaurate, tin octoate, and 1,4-diazabicyclo[2,2,2]octane, can be used. In the present invention, tin-based catalysts, which facilitate production of urethane polymers having higher molecular weights are preferably used.

The polyol that constitutes the urethane polymer has at least two hydroxyl groups per molecule.

Low molecular weight polyols include dihydric alcohols such as ethylene glycol, diethylene glycol, propylene glycol, butylene glycol, and hexamethylene glycol; trihydric alcohols such as trimethylolpropane and glycerol; and tetrahydric alcohols such as pentaerythritol.

Examples of the high molecular weight polyol include ethylene oxide, propylene oxide, polyether polyol obtained by addition polymerization of tetrahydrofuran, polyester polyols that are condensation products between the above-mentioned dihydric alcohol, such as dipropylene glycol, 1,4-butanediol, 1,6-hexanediol or neopentyl glycol with a dibasic acid such as adipic acid, azelaic acid, or sebacic acid, acryl polyols, carbonate polyols, epoxy polyols, and caprolactone polyols. Among these, polyether polyols and polyester polyols are preferable. Examples of the acrylic polyol include copolymers of hydroxyl group-containing monomers such as hydroxyethyl (meth)acrylate and hydroxypropyl (meth)acrylate and in addition, copolymers of a hydroxyl group-containing substance and an acrylic-based monomer. The epoxy polyols include amine-modified epoxy resins.

In the present invention, the above-mentioned polyols can be used singly or in combinations of two or more of them taking into consideration the characteristics of the base material, solubility in the radical polymerizable monomer, reactivity with isocyanate and so on. When strength is required, it is effective to make a crosslinking structure in the polymer by use of a triol or to increase the amount of urethane hard segment by use of a low molecular weight diol. When importance is posed on elongation, it is preferable that a diol having a large molecular weight is preferable. The polyether polyols generally are inexpensive and have good water resistance. The polyester polyols have high strengths. In the present invention, the kind and amount of polyols can be selected freely depending on the utility and purpose. The kind and molecular weight of polyols, and amount to be used may be selected appropriately also from the viewpoints of the property of the base reactivity with isocyanate and compatibility with the acrylic.

As the polyisocyanates, aromatic, aliphatic, and alicyclic diisocyanates, dimers, trimers and so on of the diisocyanates may be used. Examples of the aromatic, aliphatic, and alicyclic diisocyanates include tolylene diisocyanate, diphenylmethane diisocyanate, hexamethylene diisocyanate, xylylene diisocyanate, hydrogenated xylylene diisocyanate, isophorone diisocyanate, hydrogenated diphenylmethane diisocyanate, 1,5-naphthylene diisocyanate, 1,3-phenylene diisocyanate, 1,4-phenylene diisocyanate, butane-1,4-diisocyanate, 2,2,4-trimethylhexamethylene diisocyanate, 2,4,4-trimethylhexamethylene, cyclohexane-1,4-dlisocyanate, dicyclohexylmethane-4,4-diisocyanate, 1,3-bis(isocyanatomethyl)cyclohexane, methylcyclohexane diisocyanate, and m-tetramethylxylylene diisocyanate. Also, dimers and trimers of these and polyphenylmethane polyisocyanates may be used. The trimers include isocyanurate type, biuret type, allophanate type, and so on and are used appropriately.

The polyisocyanates may be used singly or as combinations of two or more of them. The kind, combinations and so on of the polyisocyanate may be selected appropriately from the viewpoints of the properties of the base, solubility in radical-polymerizable monomer, reactivity with hydroxyl groups, and so on.

In the present invention, the amounts of the polyol component and polyisocyanate component used for forming the urethane polymer are not particularly limited as far as the content of the component of the urethane polymer having a molecular weight of 10,000 or less in a differential molecular weight curve can be made less than 10%. For example, a ratio of the amount of the polyol component to be used to that of the polyisocyanate component is such that an NCO/OH ratio (equivalent ratio) is preferably 0.8 or more and 1.20 or less, and more preferably 0.9 or more and 1.18 or less. By adjusting the NCO/OH ratio to be 0.8 or more and 1.20 or less, the urethane polymer can be rendered a high polymer to decrease low molecular weight urethane polymers having a molecular weight of 10,000 or less. When the NCO/OH ratio is less than 0.8, the molecular chain of the urethane polymer can not be extended long enough so that the urethane polymer tends to have a decreased cohesive property, and film strength and elongation tend to be decreased. On the other hand, when the NCO/OH ratio is 1.20 or less, the urethane polymer can have a sufficient flexibility.

The molecular weight of the urethane polymer can be determined by sufficiently air-drying the urethane polymer and measuring by using gel permeation chromatography. Note, however, that the solution used for measurement is a filtrate obtained by dissolving a urethane polymer in an eluent and filtering the solution through a 0.45-µm membrane filter. This molecular weight is calculated in terms of TSK standard polystyrene. The content of the component having a molecular weight of 10,000 or less can be obtained from a ratio of areas of the obtained differential molecular weight curve.

In the formation of the vinyl polymer that constitutes the composite film, preferably radical polymerizable monomers are used. Acrylic monomers having radical polymerizable unsaturated double bonds are particularly preferable from the viewpoint of reactivity. The kind, combinations and amounts of the radical polymerizable monomers are appropriately determined considering compatibility with urethane, polymerizability upon photocuring, for example, with radiation, and the characteristics of the polymer to be obtained.

Examples of the acrylic-based monomer include (meth)acrylic acid, methyl (meth)acrylate, ethyl (meth)acrylate, propyl (meth)acrylate, butyl (meth)acrylate, pentyl (meth)acrylate, hexyl (meth)acrylate, 2-ethylhexyl (meth)aorylate, octyl (meth)acrylate, isooctyl (meth)aorylate, nonyl (meth)acrylate, and isononyl (meth)acrylate, isobornyl (meth)acrylate, 2-hydroxylethyl (meth)acrylate, 4-hydroxybutyl (meth)acrylate, and 6-hydroxyehxyl (meth)acrylate. These acrylic-based monomers can be used singly or in combinations of two or more of them.

Further, together with these acrylic monomers, monomers such as vinyl acetate, vinyl propionate, styrene, acrylamide, methacrylamide, mono- or diesters of maleic acid and derivatives thereof, N-methylolacrylamide, glycidyl acrylate, glycidyl methacrylate, N,N-dimethylaminoethyl acrylate, N,N-dimethylaminopropylmethacrylamide, 2-hydroxypropyl acrylate, acryloylmorpholine, N,N-dimethylacrylamide, N,N-diethylacrylamide, imide acrylate, N-vinylpyrrolidone, oligoester acrylate, E-caprolactone acrylate, dicyclopentanyl (meth)acrylate, dicyclopentenyl (meth) acrylate, methoxylated cyclododecatriene acrylate, and methoxyethyl acrylate may be copolymerized. The kind and amount of the copolymerizable monomers can be determined as appropriate taking into consideration the properties of the resultant composite film and so on.

Further, the acrylic polymer may contain a polyfunctional monomer as long as the properties are not disadvantaged. Examples of the polyfunctional monomer include ethylene glycol di(meth)acrylate, propylene glycol di(meth)acrylate, hexanediol di(meth)acrylate, neopentyl glycol di(meth)acrylate, trimethylolpropane tri(meth)acrylate, pentaerythritol tri(meth)acrylate, dipentaerythritol hexa(meth)acrylate, urethane acrylate, epoxy acrylate, and polyester acrylate.

It is preferable that the polyfunctional monomers are contained in amounts of 1 part by weight or more and 20 parts by weight or less per 100 parts by weight of the vinyl-based monomer. When the content of the polyfunctional monomers is 1 part by weight or more per 100 parts by weight of the vinyl-based monomer, the cohesive force of the intermediate layer is sufficient, so that cutting scraps will not increase. On the other hand, when the content of the polyfunctional monomers is 20 parts by weight or less per 100 parts by weight of the vinyl-based monomer, the elastic modulus of the polymer does not increase too much, so that the resultant composite film can follow up unevenness of pattern on the surface of a wafer.

In the formation of the composite film in the present invention, polyfunctional monomers such as trimethylolpropane triacrylate and dipentaerythritol hexaacrylate may be used as crosslinking agents.

In the present invention, the composite film may contain commonly used additives, for example, ultraviolet absorbents, antioxidants, fillers, pigments, colorants, flame retardants, and antistatic agents as necessary as far as they do not deteriorate the effects of the present invention. The additives may be used in amounts that are usually used depending on their kind. The additives may be added in advance prior to the polymerization reaction of a polyisocyanate and a polyol. Alternatively, they may be added prior to polymerization of a urethane polymer with a reactive monomer.

To adjust the viscosity upon coating, the composite film may contain a small amount of a solvent. The solvent may be selected appropriately from commonly used solvents. Examples of such a solvent include ethyl acetate, toluene, chloroform, and dimethylformamide.

In the present invention, the composite film can be formed by performing reaction of a polyol with an isocyanate in a radical polymerizable monomer as a diluent to form a urethane polymer, coating a mixture containing the radical polymerizable monomer and the urethane polymer as major components on a base, and curing it by irradiating radiation, for example, ionizing radiation such as α-ray, β-ray, γ-ray, neutron beam, or electron beam, radiation such as ultraviolet ray, or visible light depending on the kind of the used photopolymerization initiator.

Specifically, after a polyol is dissolved in an acrylic-based monomer, a diisocyanate or the like is added to allow it to react with the polyol to adjust the viscosity, and the mixture is coated, for example, on a base, and curing the coating by using a low-pressure mercury lamp or the like to provide a composite film. In this method, the acrylic-based monomer may be added at one time during the urethane synthesis or in several times dividedly. Alternatively, the polyisocyanate is dissolved in the acrylic-based monomer, and then the polyol may be reacted with the resultant. By this method, the molecular weight is not limited and polyurethanes having high molecular weights can be produced. So, the molecular weight of the finally obtained polyurethane can be designed to a desired size.

In this case, to avoid inhibition of polymerization by oxygen, a release-treated sheet can be placed on the mixture of the urethane polymer and the radical polymerizable monomer coated on the base to shut out oxygen. Also, the base may be placed in a vessel filled with an inert gas to decrease the concentration of oxygen.

In the present invention, the kind of radiation and so on and the kind and the like of the lamp to be used for irradiation may be selected appropriately, and low pressure lamps such as a fluorescent chemical lamp, a black light, and a bactericidal lamp as well as high pressure lamps such as a metal halide lamp and a high pressure mercury lamp can be used.

The dose of ultraviolet or the like may be set up optionally depending on the characteristics required for the film. Generally, the dose of ultraviolet ray is selected within the range of 100 to 5,000 mJ/cm², preferably 1,000 to 4,000 mJ/cm², and more preferably 2,000 to 3,000 mJ/cm². When the dose of ultraviolet ray is less than 100 mJ/cm², sufficient degree of polymerization may not be obtained, while a dose of ultraviolet ray being more than 5,000 mJ/cm² may cause deterioration of the characteristic of the intermediate layer.

Further, the temperature at which ultraviolet ray is irradiated is not particularly limited and can be set up optionally. However, when the temperature is too high, termination reaction tends to occur due to the heat of polymerization and thus cause a reduction in the characteristics of the intermediate layer. Usually, the temperature is 70°C or less, preferably 50°C or less, and more preferably 30°C or less.

The mixture that contains the urethane polymer and the radical polymerizable monomer as major components contains an optical polymerization initiator. Examples of the optical polymerization initiator that can be preferably used in the present invention include benzoin ethers such as benzoin methyl ether and benzoin isopropyl ether; substituted benzoin ethers such as anisole methyl ether; substituted acetophenones such as 2,2-diethoxyacetophenone and 2,2-dimethoxy-2-phenylacetophenone; substituted α-ketols such as 1-hydroxycyclohexyl phenyl ketone and 2-methyl-2-hydroxypropiophenone; aromatic sulfonyl chloride such as 2-naphthalenesulfonyl chloride; optically active oximes such as 1-phenyl-1,1-propanedlone-2-(o-ethoxycarbonyl)oxime.

The thicknesses of the intermediate layer in the pressure-sensitive adhesive layer of the present invention can be selected appropriately depending on the purpose and so on. In particular, when the pressure-sensitive adhesive sheet is used in processing high precision parts, the intermediate layer is as thick as preferably 10 to 300 µm, more preferably about 50 to about 250 µm, and particularly preferably 50 to 200 µm.

The pressure-sensitive adhesive sheet of the present invention has a pressure-sensitive adhesive layer on the intermediate layer. The pressure-sensitive adhesive layer must have a moderate adhesive force to hold the articles securely while processing articles such as semiconductor wafers and also to be peeled off easily from the articles without loads on the articles after the processing.

The composition of pressure-sensitive adhesive that constitutes such a pressure-sensitive adhesive layer is not particularly limited and known pressure-sensitive adhesives used for bonding and fixing semiconductor wafers and so on can be used. For example, rubber-based pressure-sensitive adhesives that contain a rubber-based polymer such as natural rubber or styrene-based copolymer as a base polymer, silicone-based pressure-sensitive adhesives, acrylic-based pressure-sensitive adhesives, polyvinyl ether-based pressure-sensitive adhesives and so on can be used. Among these, acrylic-based pressure-sensitive adhesives that contain acrylic-based polymers as a base polymer are preferable from the viewpoints of adhesion to semiconductor wafers, washability of the semiconductor wafers after the peeling with super pure water or organic solvents such as alcohols.

Examples of the acrylic-based polymers include those acrylic polymers obtained by polymerizing a monomer component consisting of one or more monomers selected from the group consisting of alkyl (meth)acrylates (for example, linear or branched alkyl esters having 1 to 30 carbon atoms, particularly 4 to 18 carbon atoms in the alkyl moiety, such as methyl esters, ethyl esters, propyl esters, isopropyl esters, butyl esters, isobutyl esters, s-butyl esters, t-butyl esters, pentyl esters, isopentyl esters, hexyl esters, heptyl esters, octyl esters, 2-ethylhexyl esters, isooctyl esters, nonyl esters, decyl esters, isodecyl esters, undecyl esters, dodecyl esters, tridecyl esters, tetradecyl esters, hexadecyl esters, octadecyl esters, and eicosyl esters) and cycloalkyl (meth)acrylates (for example, cyclopentyl esters, cyclohexyl esters and so on) as monomer components.

Note that the term "(meth)acrylates" refer to acrylates and/or methacrylates (i.e., acrylates, methacrylates, or both acrylates and methacrylates). The term "(meth)" as used herein for all the occurrences shall be understood similarly.

To improve cohesion force, heat resistance and the like properties, the acrylic-based polymer may contain a unit that corresponds to other monomer component copolymerizable with the alkyl (meth)acrylate or cycloalkyl ester.

Examples of such a monomer component include carboxylic group-containing monomers such as acrylic acid, methacrylic acid, carboxyethyl (meth)acrylate, carboxypentyl (meth)acrylate, itaconic acid, maleic acid, fumaric acid, and crotonic acid; acid anhydride monomers such as maleic anhydride and itaconic anhydride; hydroxyl group-containing monomers such as 2-hydroxylethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)acrylate; sulfonic group-containing monomers such as styrenesulfonic acid, allyl sulfonate, 2-(meth)acrylamide-2-methylpropanesulfonate, (meth)acrylamidepropanesulfonate, sulfopropyl (meth)acrylate, and (meth)acryloyloxynaphthalenesulfonate; phosphate group-containing monomers such as 2-hydroxyethylacryloyl phosphate; acrylamide, and acrylonitrile and so on.

These copolymerizable monomer components can be used singly, or two or more of them can be used in combination. The amount of the copolymerizable monomers is preferably 40% by weight or less based on the total monomer components.

Further, the acrylic-based polymer may contain a polyfunctional monomer for crosslinking. Examples of the polyfunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy(meth)acrylate, polyester (meth)acrylate, and urethane (meth)acrylate.

Also, these polyfunctional monomers can be used singly, or two or more of them can be used in combination. The amount of the polyfunctional monomer to be used is preferably 30% by weight or less based on the total monomer components from the viewpoint of adhesive properties.

The polymerization method for forming the acrylic-based polymer may be any of a solution polymerization method, an emulsion polymerization method, a mass polymerization method, a suspension polymerization method and so on. The pressure-sensitive adhesive layer preferably contains a smaller amount of low molecular weight substances in order not to contaminate the affixing surface of the articles such as semiconductor wafers. From this viewpoint, the acrylic-based polymer has a weight-average molecular weight of, preferably about 300,000 or more, more preferably about 400,000 to about 3,000,000.

To Increase the weight-average molecular weight of the acrylic-based polymer, the acrylic-based polymer may contain a polyisocyanate compound, an epoxy compound, an aziridine compound, a melamine-based crosslinking agent and so on. The amounts thereof may be appropriatly determined depending on balance with the base polymer to be crosslinked and further the intended utility of the resultant pressure-sensitive adhesive. Generally, about 1 to about 5 parts by weight of such additives based on 100 parts by weight of the base polymer. Further, the pressure-sensitive adhesive may contain in addition to the above-mentioned components, various conventional additives such as tackifiers and antioxidants as necessary.

In the present invention, preferably a radiation-curing type pressure-sensitive adhesive is used as the pressure-sensitive adhesive. For example, the radiation-curing type pressure-sensitive adhesive can be obtained by blending the pressure-sensitive adhesive substance with an oligomer component that cures upon irradiation of radiation and so on to form a low adhesive substance. A pressure-sensitive adhesive sheet with its pressure-sensitive adhesive layer made of the radiation-curing type pressure-sensitive adhesive can be readily affixed to an article with ease since the pressure-sensitive adhesive is imparted plastic flowability by the oligomer component, while when the sheet is to peeled off, it can be readily released from the articles such as semiconductor wafers by irradiation of radiation to form a low-adherent substance.

The radiation curing type pressue-sensitive adhesive that can be used has a radiation curing functional group such as a carbon-carbon double bond in the molecule thereof and exhibits tackiness. For example, use can be made of an additive-type radiation curing type pressure-sensitive adhesive that is obtained by blending a conventional pressure-sensitive adhesive with a radiation curing monomer or oligomer component, an intrinsic type radiation curing type pressure-sensitive adhesive that contains a base polymer having a carbon-carbon double bond in the main chain or at the terminal or terminals of the main chain, and so on. Radiations that can be used to cure the pressure-sensitive adhesive layer include, for example, X-ray, electron beam, and ultraviolet ray and so on. It is preferable that ultraviolet ray is used in view of ease of handling. However, the present invention is not limited thereto.

As the general pressure-sensitive adhesive that constitutes the additive-type radiation curing type pressure-sensitive adhesive, pressure-sensitive adhesives such as the above-mentioned acrylic-based pressure-sensitive adhesives and rubber-based pressure-sensitive adhesives can be used.

Examples of the monomer having a radiation curing functional group include urethane oligomers, urethane (meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxypenta(meth)acrylate, dipentaerythritol hexa(meth)acrylate, and 1,4-butanediol di(meth)acrylate and so on. On the other hand, radiation curing oligomer components include various oligomers such as urethane-based oligomers, polyether-based oligomers, polyester-based oligomers, polycarbonate-based oligomers, polybutadiene-based oligomers and so on. Those oligomers that have a molecular weight in the range of about 100 to about 30,000 are suitable. The blending amount of the monomer component or oligomer component having a radiation curing functional group is, for example, preferably about 5 to about 500 parts by weight, more preferably about 40 to about 150 parts by weight based on 100 parts by weight of the base polymer such as the acrylic-based polymer that constitutes the pressure-sensitive adhesive.

The intrinsic type radiation curing type pressure-sensitive adhesives do not have to contain the oligomer component or the like that is a low polymerizing component and does not contain it much. Accordingly, there does not occur the situation in which the oligomer component or the like migrates in the pressure-sensitive adhesive with time, so that a pressure-sensitive adhesive layer having a stable layer construction can be formed.

In the intrinsic type radiation curing type pressure-sensitive adhesive, polymers that have a carbon-carbon double bond and have tackiness can be used as the base polymers without limitations. Such base polymers preferably are acrylic-based polymers in their basic skeleton. The acrylic-based polymers that are used here can be the same as those acrylic-based polymers already exemplified in the explanation of the acrylic-based pressure-sensitive adhesives.

The method of introducing a carbon-carbon double bond into an acrylic-based polymer as a basic skeleton is not particularly limited and various methods may be adopted. In the present invention, it is preferable that the carbon-carbon double bond is introduced into side chain of the acrylic-based polymer to form a base polymer having a carbon-carbon double bond. Specifically, the carbon-carbon double bond can be introduced into sidechain of the acrylic-based polymer, for example, by preliminarily copolymerizing an acrylic-based polymer with a monomer having a first functional group, and then reacting the resultant polymer with a compound having a carbon-carbon double bond and a second functional group that can react with the first functional group by a condensation or addition reaction such that the radiation curing of the carbon-carbon double bond is maintained.

Examples of combination of the functional group of amonomer to be copolymerized with the acrylic-based polymer and a functional group that can react with the functional group of the monomer are presented below. Such combinations include, for example, a carboxyl group and an epoxy group, a carboxyl group and an aziridyl group, a hydroxyl group and an isocyanate group, and so on. Among the combinations of functional groups, the combination of a hydroxyl group and an isocyanate group is preferable in view of ease of tracing the reaction.

Further, in the presented combinations, any of the functional groups in the combination may be present on the acrylic-based polymer as the basic skeleton. For example, in the combination of a hydroxyl group and an isocyanate group, it is preferable that the acrylic-based polymer has a hydroxyl group and the compound having a functional group that can react with the functional group of the monomer to be preliminarily copolymerized with the acrylic polymer has an isocyanete group.

In this case, examples of the compound having an isocyanate group include methacryloyl isocyanate, 2-methacryloyloxyethyl isocyanate, and m-isopropenyl-α,α-dimethylbenzyl isocyanate.

Examples of the acrylic-based polymer having a functional group (here, a hydroxyl group) include those acrylic-based polymers that are copolymerized with one or more compounds selected from the group comprising the above-mentioned hydroxyl group-containing monomers that have been exemplified in the description with respect to the acrylic-based pressure-sensitive adhesives and in addition 2-hydroxyethyl vinyl ether-based compounds, 4-hydroxybutyl vinyl-based ether compounds, and diethylene glycol monovinyl ether-based compounds.

The intrinsic type radiation curing type pressure-sensitive adhesive may be comprised singly by a base polymer having a carbon-carbon double bond but as far as its characteristics are not deteriorated, it may be blended with the above-mentioned radiation curing monomer component or oligomer component. The blending amount of the radiation curing monomer or oligomer component is in the range of usually 30 parts by weight or less, preferably 0 to 10 parts by weight based on 100 parts by weight of the base polymer.

The radiation curing type pressure-sensitive adhesives may contain a photopolymerization initiator when they are cured with radiation such as ultraviolet ray. Examples of the photopolymerization initiator include α-ketal-based compounds such as 4-(2-hydroxyethoxy)phenyl(2-hydroxy-2-propyl)ketone, α-hydroxy-α,α'-dimethylacetophenone, 2-methyl-2-hydroxypropiophenone, and 1-hydroxycyclohexyl phenyl ketone; acetophenone-based compounds such as methoxyacetophenone, 2,2-dlmethoxy-2-phenylacetophenone, 2,2-diethoxyacetophenone, and 2-methyl-1-[4-(methylthio)-phenyl]-2-morpholinopropane-1-o ne; benzoin ether-based compounds such as benzoin ethyl ether, benzoin isopropyl ether, and anisoin methyl ether; ketal-based compounds such as benzyl dimethyl ketal; aromatic sulfonyl chloride-based compounds such as 2-naphthalenesulfonyl chloride; optically active oxime-based compounds such as 1-phenone-1,1-propanedlone-2-(o-ethoxycarbonyl)oxime; benzophenone-based compounds such as benzophenone, benzoyl benzoate, and 3,3'-dimethyl-4-methoxybenzophenone; thioxanthone-based compounds such as thioxanthone, 2-chlorothloxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone, halogenated ketones, acyl phosphinoxides, and acyl phosphonates.

The amount of the photopolymerization initiator to be blended is, for example, about 1 to about 10 parts by weight, preferably about 3 to about 5 parts by weight based on 100 parts by weight of the base polymer such as acrylic-based polymer that constitutes the pressure-sensitive adhesive.
In the present invention, the pressure-sensitive adhesive layer may be formed by directly coating the above-mentioned pressure-sensitive adhesive on an intermediate layer by optionally using a solvent or the like as necessary. Alternatively, it may be formed by coating the pressure-sensitive adhesive on a release liner or the like to form a pressure-sensitive adhesive layer in advance and then applying the pressure-sensitive adhesive layer to the intermediate layer.

Further, the thickness of the pressure-sensitive adhesive layer is not particularly limited and arbitrarily selected. The thickness of the pressure-sensitive adhesive layer is preferably about 3 to about 100 µm, more preferably about 10 to about 50 µm, and particularly preferably about 10 to about 30 µm.

Referring to Fig. 1, the pressure-sensitive adhesive sheet according to an embodiment of the present invention will be explained in detail. Fig. 1 is a shematic view showing a layer construction of the pressure-sensitive adhesive sheet according to a first embodiment of the present invention. A base 1 has a composite film 2 thereon and a pressure-sensitive adhesive layer 3 is provided on the composite film 2. Note that a release sheet (not shown) may be provided on the pressure-sensitive adhesive layer 3.

The pressure-sensitive adhesive sheet of the present invention is used by a conventional method that is used when articles, for example, semiconductor wafers are processed. Here, an example case is presented where the pressure-sensitive adhesive sheet is used for polishing the backside of a semiconductor wafer. In this case, first a semiconductor wafer is mounted on a table such that a pattern surface, i.e., a surface on which a pattern such as IC circuitry is provided is up and the pressure-sensitive adhesive sheet of the present invention is superimposed on the pattern surface such that the pressure-sensitive adhesive layer side contact the pattern surface. Then, the pressure-sensitive adhesive sheet is affixed by pressing it by press means such as a press roll. Alternatively, the semiconductor wafer and the pressure-sensitive adhesive sheet are placed in a compressible vessel (for example, an autoclave) as superimposed in the above-mentioned manner and then the inner pressure of the vessel is increased to have the semiconductor wafer and the pressure-sensitive adhesive sheet affixed to each other. A press means may be used in combination. Alternatively, the semiconductor wafer and the pressure-sensitive adhesive sheet can be affixed to each other in a vacuum chamber. Alternatively, the pressure-sensitive adhesive sheet can be affixed to the semiconductor wafer by heating the pressure-sensitive adhesive sheet to a temperature equal to or less than the melting point of the base of the pressure-sensitive adhesive sheet.

The method for polishing the backside of a semiconductor wafer is performed by a conventional polishing method. For example, a semiconductor wafer onto which a pressure-sensitive adhesive sheet is affixed in the above-mentioned manner is mounted on a polisher (back grinder) used as a processing machine for polishing and the backside of the wafer is polished to a desired thickness using a CMP (Chemical Mechanical Polishing) pad. In case of a pressure-sensitive adhesive sheet of which the pressure-sensitive adhesive layer is formed from the radiation-curing type pressure-sensitive adhesive is used, radiation is irradiated to the pressure-sensitive adhesive sheet after the polishing is finished to decrease the adhesive strength of the pressure-sensitive adhesive layer before the pressure-sensitive adhesive sheet can be peeled off from the wafer.

The pressure-sensitive adhesive sheet of the present invention has a composite film constituting the intermediate layer which comprises a urethane polymer and a vinyl polymer, and the urethane polymer contains a component having a molecular weight of 10,000 or less in a content of less than 10%, so that there occurs no contamination of articles such as wafers with the urethane polymer which is otherwise contained in the composite film when they are polished after being affixed on the surface thereof with the pressure-sensitive adhesive sheet. Therefore, after the polishing wafers, the wafers have a smaller amount of residual organic components on the surface thereof so that low contamination polishing can be achieved, which avoids wire bonding failure or breakage of the sealant resin.

Since the pressure-sensitive adhesive sheet of the present invention has an intermediate layer comprised by a composite film, it can follow up unevenness of the surface of a semiconductor wafer on which it is applied. For example, when the pressure-sensitive adhesive sheet is affixed to a semiconductor wafer and the semiconductor wafer is polished to a thin film, the wafer is not damaged. In addition, since the curl of the wafer due to the residual stress in the pressure-sensitive adhesive sheet can be decreased, the finished wafers can be stored in a sole-use storage case.

### EXAMPLES

Hereinafter, the present invention is explained by examples. However, the present invention is not limited thereto. In the following examples, all parts are parts by weight.

### (Example 1)

In a reactor equipped with a condenser, a thermometer, and an agitator were charged 35 parts of t-butyl acrylate and 24.5 parts of n-butyl acrylate as a acrylic monomer, 23.1 parts of polyoxytetramethylene glycol (number-average molecular weight 650, manufactured by Mitsubishi Chemical Corporation) as a polyol,0.14 parts of 2,2-dimethoxy-1, 2-diphenylethan-1-one (registered trademark "IRGACURE 651," manufactured by Ciba Specialty Chemicals Co., Ltd.) as a photopolymerization initiator, and 0.03 parts of dibutyltin laurate as a urethane reaction catalyst. While agitating, 6.9 parts of xylylene diisocyanate was dripped and the mixture was allowed to react at 75°C for 2 hours. After the reaction mixture was cooled to room temperature, 10.5 parts of acrylic acid and 0.7 parts of trimethylolpropane triacrylate as a polyfunctional monomer were added thereto to obtain a mixture of a urethane polymer and an acrylic-based monomer. The amount of the polyisocyanate component and the polyol component used were such that NCO/OH (equivalent ratio) = 1.1. Further, measurement of the molecular weight of the urethane polymer according to the method of measuring molecular weight described hereinbelow showed that the urethane polymer had a weight average molecular weight of 215,000, and the content of the component having a molecular weight of 10,000 or less in a differential molecular weight curve was 5.45%.

The mixture of the urethane polymer and the acrylic-based monomer was coated on a 75-µm thick polyethylene terephthalate film (PET film) to a thickness after curing of 100 µm. On this was superimposed a release-treated PET film (thickness 38 µm) as a separator, and then ultraviolet ray (illuminance 200 mW/cm², light amount 3500 mJ/cm²) from a high-pressure mercury lamp was Irradiated to cure the coating to form a complex film as an intermediate layer on the PET film. Thereafter, the covered release-treated PET film was peeled to obtain a laminate sheet of PET/composite film (support).

Then, a blend of 78 parts of ethyl acrylate, 100 parts of butyl acrylate, and 40 parts of 2-hydroxyethyl acrylate was allowed to copolymerize in a toluene solution to obtain an acrylic-based copolymer having a number-average molecular weight of 300,000. Subsequently, 43 parts of 2-methacryloyloxyethyl isocyanate was reacted with the acrylic-based copolymer by addition reaction to introduce carbon-carbon double bonds in the molecule of the acrylic-based copolymer. A mixture of 1 part of polyisooyanate-based crosslinking agent and 3 parts of an acetophenone-based photopolymerization initiator per 100 parts of the resultant polymer was coated on a surface of the composite film of the obtained laminate sheet (support) to form a 30-µm-thick pressure-sensitive adhesive layer, thus preparing a pressure-sensitive adhesive sheet.

The obtained pressure-sensitive adhesive sheet was evaluated for contamination, curl, sag, and crack. Results are shown in Table 1.

### (Example 2)

A laminate sheet (support) was prepared in the same manner as that in Example 1 except that the blending amounts of the polyol and the polyisocyanate were changed to 23.6 parts of polyoxytetramethylene glycol and 6.4 parts of xylylene diisocyanate. Further, using the obtained laminate sheet, a pressure-sensitive adhesive layer was formed on a surface of the composite film in the same manner as that in Example 1 to prepare a pressure-sensitive adhesive sheet.

Note that the amounts of the polyisocyanate component and the polyol component used were such that NCO/OH (equivalent ratio) = 1.0. Further, measurement of the molecular weight of the urethane polymer according to the method of measuring molecular weight described hereinbelow indicated that the urethane polymer had a weight average molecular weight of 142,000, and the content of the component having a molecular weight of 10,000 or less in a differential molecular weight curve was 9.13%.

The obtained pressure-sensitive adhesive sheet was evaluated for contamination, curl, sag, and crack. Results are shown in Table 1.

### (Example 3)

A laminate sheet (support) was prepared in the same manner as that in Example 1 except that the blending amounts of the polyol and the polyisocyanate were changed to 22.8 parts of polyoxytetramethylene glycol and 7.2 parts of xylylene diisocyanate. Further, using the obtained laminate sheet, a pressure-sensitive adhesive layer was formed on a surface of the composite film in the same manner as that in Example 1 to prepare a pressure-sensitive adhesive sheet.

Note that the amounts of the polyisocyanate component and the polyol component used were such that NCO/OH (equivalent ratio) = 1.15. Further, measurement of the molecular weight of the urethane polymer according to the method of measuring molecular weight described hereinbelow indicated that the urethane polymer had a weight average molecular weight of 176,000, and the content of the component having a molecular weight of 10,000 or less in a differential molecular weight curve was 7.88%.

The obtained pressure-sensitive adhesive sheet was evaluated for contamination, curl, sag, and crack. Results are shown in Table 1.

### (Comparative Example 1)

A laminate sheet (support) was prepared in the same manner as that in Example 1 except that the blending amounts of the polyol and the polyisocyanate were changed to 22.1 parts of polyoxytetramethylene glycol and 7.9 parts of xylylene diisocyanate. Further, using the obtained laminate sheet, a pressure-sensitive adhesive layer was formed on a surface of the composite film in the same manner as that in Example 1 to prepare a pressure-sensitive adhesive sheet.

Note that the amounts of the polyisocyanate component and the polyol component used were such that NCO/OH (equivalent ratio) = 1.25. Further, measurement of the molecular weight of the urethane polymer according to the method of measuring molecular weight described hereinbelow indicated that the urethane polymer had a weight-average molecular weight of 98,000, and the content of the component having a molecular weight of 10,000 or less in a differential molecular weight curve was 12.51%.

The obtained pressure-sensitive adhesive sheet was evaluated for contamination, curl, sag, and crack. Results are shown in Table 1.

### (Comparative Example 2)

A laminate sheet (support) was prepared in the same manner as that in Example 1 except that the blending amounts of the polyol and the polyisocyanate were changed to 24.7 parts of polyoxytetramethylene glycol and 5.3 parts of xylylene diisocyanate. Further, using the obtained laminate sheet, a pressure-sensitive adhesive layer was formed on a surface of the composite film in the same manner as that in Example 1 to prepare a pressure-sensitive adhesive sheet.

Note that the amounts of the polyisocyanate component and the polyol component used were such that NCO/OH (equivalent ratio) = 0.75. Further, measurement of the molecular weight of the urethane polymer according to the method of measuring molecular weight described hereinbelow indicated that the urethane polymer had a weight-average molecular weight of 37,000, and the content of the component having a molecular weight of 10,000 or less in a differential molecular weight curve was 19.86%.

The obtained pressure-sensitive adhesive sheet was evaluated for contamination, curl, sag, and crack. Results are shown in Table 1.

### (Reference Example)

To remove influence of contamination caused by the urethane polymer contained in the intermediate layer, a pressure-sensitive adhesive sheet having no intermediate layer was prepared as a reference example. That is, a 75-µm-thiok PET film was used as a base and in the same manner as that in Example 1, the prepared pressure-sensitive adhesive was coated on the PET film to form a 30-µm-thick pressure-sensitive adhesive layer, thus providing a pressure-sensitive adhesive sheet having a pressure-sensitive adhesive layer on the PET film.

### <Evaluation Tests>

### (1) Measurement of molecular weight

The urethane polymer was sufficiently air-dried and this urethane polymer (solids) was measured by gel permeation chromatography under the following conditions. Note, however, that the solution used for measurement was a filtrate obtained by dissolving a urethane polymer in an eluent and filtering the solution through a 0.45-µm membrane filter. The results were calculated in terms of "TSK Standard Polystyrene" to obtain a differential molecular weight curve. From ratios of areas of the obtained differential molecular weight curve, the contents of the components having molecular weights of 100,000 or less in the intermediate layer were obtained.
GPC apparatus: HLC-8120GPC, manufactured by TOSOH.
Column: TSK gel Super HZM-H/HZ4000/HZ3000/HZ2000
Column size: 6.0 mm I.D.X 150 mm
Eluant: THF
Flow rate: 0.6 ml/min
Concentration: 0.1 wt%
Injection amount: 20 µl
Column temperature: 40°C

### (2) Evaluation of contamination

The obtained pressure-sensitive adhesive sheets were evaluated for contamination based on the evaluation method described below.

That is, the obtained pressure-sensitive adhesive sheets were each affixed to a silicon wafer (3 to 4 atomic %) using a tape affixing machine "DR8500" manufactured by Nitto Seiki Co. , Ltd. (affixing pressure: 2 MPa; affixing speed: 12 m/min). The resultant was left to stand in an atmosphere at 25°C for 24 hours. Thereafter, the pressure-sensitive adhesive sheet was peeled by using a tape peeling machine "HR8500" manufactured by Nitto Seiki Co., Ltd. (peeling speed: 12 m/min; peeling angle: 180°). Organic substances, if any, transferred onto the wafer were measured by using an X-rayphotoeleotron spectrometer (XPS). Wafers having affixed thereon no pressure-sensitive adhesive sheet at all were also analyzed in the same manner as described above. Then, the amounts of the transferred organic substances were evaluated based on an increase in atomic % of the detected carbon atom. The atomic % of the carbon atom was calculated from respective elemental ratios (total 100%) of carbon, nitrogen, oxygen, silicon and so on.
XPS apparatus: ESCA "Quantum 2000, "manufactured by Ulvac-Phi, Inc.
X-ray setting: Point analysis of 200-µm-diameter [30W (15 kV)]
X-ray source: Monochromatic Alkα
Photoelectron takeoff angle: 45°
Vacuum degree: 5×10⁻⁹ torr
Neutralizing condition: Neutralization gun and ion gun in combination

For narrow scan spectra, the peak ascribable to the C-C bond of Cls was amended to 285.0 eV.

### (3) Evaluation of Curl, Sag, Crack

Twenty (20) 8-inch wafers having a thickness of 625 µm were provided. On these wafers were affixed the obtained pressure-sensitive adhesive sheets by using a tape affixing machine "DR-8500III" manufactured by Nitto Seiki Co., Ltd. Each of the wafers with the pressure-sensitive adhesive sheet affixed thereto was ground to a thickness of 50 µm by using a silicon wafer grinder manufactured by Disco Co., Ltd. and the resultant was evaluated as described below. Results obtained are shown in Table 1.

### (i) Curl

Silicon wafers after the grinding with the pressure-sensitive adhesive sheet thereon were each left to stand on a flat plate so that the pressure-sensitive adhesive layer side was up, and a distance between the most lifted up portion of the wafer (usually an edge of the wafer) and the surface of the flat plate was measured. The obtained distances were defined as curls. Then, an average of curls was calculated from measured values. Note, however, that curl was indicated as an average of measured values on 20 wafers.

### (ii) Sag

Silicon wafers after the grinding with the pressure-sensitive adhesive sheet thereon were stored in a cassette for storing 8-inch wafers with the wafer surface on up. A distance between the position of the highest part and the position of the lowest part of the wafer that curved due to the weight of itself was defined as a sag amount. Note, however, that sag was indicated as an average of measured values on 20 wafers.

### (iii) Crack

The number of wafers in which crack occurred during grinding thereof was counted. Note, however, that crack was indicated as an average of measured values on 5 wafers.

**Table 1**

| | Intermediate layer (Polyurethane) | | Evaluation | | | |
|---|---|---|---|---|---|---|
| | Weight-average molecular weight | Ratio of Molecular Weight of 10,000 or less | Contamination | Curl | Sag | Crack |
| | | (%) | (%) | (mm) | (mm) | (number of wafers) |
| Example 1 | 21.5 | 5.45 | 13 | 3 | 7 | 0 |
| Example 2 | 14.2 | 9.13 | 11 | 4 | 7 | 0 |
| Example 3 | 17.6 | 7.88 | 11 | 2 | 5 | 0 |
| Comparative Example 1 | 9.8 | 12.51 | 26 | 4 | 7 | 0 |
| Comparative Example 2 | 3.7 | 19.86 | 32 | 6 | 10 | 2 |
| Reference Example | - | - | 10 | - | - | - |

Table 1 indicates that the wafers processed using the pressure-sensitive adhesive sheets of Examples 1 to 3 of the present invention showed curls of 5 mm or less and sags of less than 10 mm, and caused no problems to occur while they were being transported to subsequent processing steps. Further, when wafers were processed by grinding them to a thickness of 50 µm using the pressure-sensitive adhesive sheets of Examples 1 to 3, none of the wafers showed cracks. Furthermore, the pressure-sensitive adhesive sheets of Examples 1 to 3 showed less contamination on the wafers, so that processing with low contamination can be realized. Since low contamination can be realized, there occur neither wire bonding failure nor breakage of the sealant resin.

Further, it revealed that the same level of low contamination as that of the contamination of Reference Example in which no composite film was arranged as an intermediate layer could be achieved. That is, while the conventional pressure-sensitive adhesive sheets the amount of contamination on the surface of the wafer increases due to the urethane polymer that constitutes the intermediate layer, the pressure-sensitive adhesive sheets of Examples 1 to 3 of the present invention show no contamination due to the urethane polymer present in the intermediate layer.

On the other hand, in Comparative Examples 1 and 2 in which the content of the urethane polymer having a molecular weight of 10,000 or less was 10% or more proved to show contamination on the wafer to a greater extent.

According to the present invention, a pressure-sensitive adhesive sheet can be provided that can prevent damages of articles such as semiconductor articles and optical articles when they are processed, that can follow up surface unevenness of the articles such as wafers, and that can achieve low contamination and also a method of producing such a pressure-sensitive adhesive sheet can be provided.

### [Industrial Applicability]

The pressure-sensitive adhesive sheet of the present invention can be advantageously used as a pressure-sensitive adhesive sheet for use in processing semiconductor wafers that are used when the backside of semiconductor wafers is ground or semiconductor wafers are diced. Further, it causes no interface fracture between the surface of aluminum and gold wire in wire bonding performed at the time of manufacturing semiconductor chips, thus enabling the wafer to maintain a high shear strength. Furthermore, making the most of low contamination, it can be used in a variety of applications in which peeling of the pressure-sensitive adhesive sheet during the use or after the use thereof is involved, for example, as a pressure-sensitive adhesive sheet for protecting the surface of articles or for preventing breakage of the articles in the manufacture of high-precision processed parts, for example, various engineering materials, in particular semiconductors, circuits, various printed boards, various masks, and lead frames.

## Claims

1. A pressure-sensitive adhesive sheet comprising a base material, an intermediate layer, and a pressure-sensitive adhesive layer in this order, wherein the intermediate layer includes a composite film containing a urethane polymer and a vinyl-based polymer as active ingredients and the urethane polymer contains a component having a molecular weight of 10,000 or less in a differential molecular weight curve in a content of less than 10%.

2. The pressure-sensitive adhesive sheet as claimed in claim 1, wherein the vinyl-based polymer is an acrylic-based polymer.

3. The pressure-sensitive adhesive sheet as claimed in claim 1, wherein the composite film is formed by reacting a polyol and polyisocyanate in a radical-polymerizable monomer to form a urethane polymer, coating a mixture containing the urethane polymer and the radical-polymerizable monomer on a base, and irradiating radiation to the coating to cure it.

4. The pressure-sensitive adhesive sheet as claimed in claim 3, wherein the radical-polymerizable monomer is an acrylic-based monomer.

5. The pressure-sensitive adhesive sheet as claimed in claim 3, wherein an amount of the polyol used is such that an NCO/OH ratio (equivalent ratio) is 0.8 or more and 1.20 or less.

6. The pressure-sensitive adhesive sheet as claimed in claim 3, wherein a dose of the ultraviolet ray is 100 mJ/cm² or more and 5,000 mJ/cm² or less.

7. The pressure-sensitive adhesive sheet as claimed in claim 3, wherein the composite film further contains a polyfunctional monomer.

8. The pressure-sensitive adhesive sheet as claimed in claim 1, wherein the composite film further contains a polyfunctional monomer.

9. A method of producing a pressure-sensitive adhesive sheet, comprising:
coating a mixture containing a urethane polymer and a radical-polymerizable monomer on a base material,
irradiating radiation to the coating to cure the mixture to form a composite film, and
providing a pressure-sensitive adhesive layer on the composite film.

10. The method of producing a pressure-sensitive adhesive sheet as claimed in claim 9, wherein the mixture is produced by reacting a polyol and a polyisocyanate in the radical-polymerizable monomer to form the urethane polymer.

11. The method of producing a pressure-sensitive adhesive sheet as claimed in claim 9, wherein the radical-polymerizable monomer is an acrylic-based monomer.

12. The method of producing a pressure-sensitive adhesive sheet as claimed in claim 9, wherein the urethane polymer contains a component having a molecular weight of 10,000 or less in a differential molecular weight curve in a content of less than 10%.

13. The method of producing a pressure-sensitive adhesive sheet as claimed in claim 10, wherein the radical-polymerizable monomer is an acrylic-based monomer.

14. A method of processing an article, comprising:
affixing a pressure-sensitive adhesive sheet to an article; and
high-precision processing the article in a held and/or protected state,
wherein the pressure-sensitive adhesive sheet has a base material, an intermediate layer, and a pressure-sensitive adhesive layer in order, wherein the intermediate layer includes a composite film containing a urethane polymer and a vinyl-based polymer as active ingredients and the urethane polymer contains a component having a molecular weight of 10,000 or less in a differential molecular weight curve in a content of less than 10%.

15. The method of processing an article as claimed in claim14, wherein the composite film is formed by reacting a polyol and polyisocyanate in a radical-polymerizable monomer to form a urethane polymer, coating a mixture containing the urethane polymer and the radical-polymerizable monomer on a base, and irradiating radiation to the coating to cure the mixture.
